# EUROPEAN PATENT APPLICATION

(11) **EP 4 714 900 A1**
(43) Date of publication of application: **25.03.2026**
(21) Application number: 25203224.8
(22) Date of filing: 19.09.2025
(51) Int. Cl.: B81C 1/00, B81C 99/00, G03F 1/62, C01B 32/16

(54) **METHOD OF PREPARING FREE-STANDING FILM OF HARM-STRUCTURES AND APPARATUS**

(30) Priority: 20.09.2024 FI 20246146
(71) Applicant: Canatu Finland Oy, 01720 Vantaa (FI)
(72) Inventor: MIKLADAL, Bjørn, 01720 Vantaa (FI); YURTTAGÜL, Nikolai, 01720 Vantaa (FI)
(74) Representative: Papula Oy

(57) **Abstract**

Disclosed is a method of preparing a free-standing film of high aspect ratio molecular structures (HARM-structures). A second frame is arranged from an opening of a first frame to a position where the second frame is in contact with a film of HARM-structures for stretching the film into a stretched position where the second region of the film is supported by the second frame as the free-standing film. An evaporating wetting agent forms a contact surface between the second frame and the second region of the film. The film is had in the stretched position at a moment when the evaporating wetting agent evaporates so that the second region of the film adheres to the second frame. The second region of the film is separated from the first frame.

## Description

### FIELD

The present invention relates to preparation of a free-standing film of high aspect ratio molecular structures (HARM-structures).

### BACKGROUND

Preparing a free-standing film of HARM-structures is a delicate process, where the quality of the film needs to be maintained without breaking the film. Constant attempts to improve the preparation techniques are ongoing.

### SUMMARY

It is an objective to provide a method and an apparatus for improving preparing a free-standing film of high aspect ratio molecular structures (HARM-structures or HARMS).

The expression "HARM-structures" or "HARM-structures" may herein refer to nanostructures, i.e. structures with one or more characteristic dimensions in nanometer scale, i.e. less or equal than about 100 nanometers. "High aspect ratio" may herein refer to dimensions of the conductive structures in two perpendicular directions being in significantly different magnitudes of order. For example, a nanostructure may have a length which is 50-10000 or more times higher than its thickness and/or width. In a film of HARM-structures, a great number of said nanostructures can be interconnected with each other to form a network of interconnected molecules. As considered at a macroscopic scale, a HARMS network can form a solid, monolithic material in which the individual molecular structures can be disoriented or non-oriented, i.e. are oriented substantially randomly. Various types of HARM-structure networks can be produced in the form of thin transparent layers with reasonable resistivity, which can be understood for example in terms of sheet resistance to optical transparency ratio. For instance, any film as disclosed herein may have a sheet resistance of 35Ω/sq at 90% transmittance but this can vary, for example depending on application.

According to a first aspect, a method of preparing a free-standing film of HARM-structures is provided. The method may comprise receiving a film of HARM-structures on a first frame. The film of HARM-structures has a first region adhering to the first frame and a second region supported across an opening of the first frame. The method comprises depositing an evaporating wetting agent on an interface to be formed between a second frame for supporting the second region as a free-standing film and the film of HARM-structures. The method then comprises, with relative movement between the first frame and the second frame, arranging the second frame from the opening of the first frame to a position where the second frame is in contact with the film of HARM-structures for stretching the film of HARM-structures into a stretched position where the second region of the film of HARM-structures is supported by the second frame as the free-standing film. This allows a stretching force to be temporarily effected on the film of HARM-structures perpendicularly to the film, or the film plane thereof. The relative movement implies that the first frame and/or the second frame may be moved, i.e. either or both of the frames may be moved, as long as there is relative movement between the two as described. The second frame can thus be pushed against the film of HARM-structures and/or the first frame with the film of HARM-structures pulled against the first frame with the relative movement. The relative movement may consist of a single linear unidirectional movement, or it may comprise multiple subsequent movements, including even back and forth movement The evaporating wetting agent forms a contact surface between the second frame and the second region of the film of HARM-structures. The method may further comprise having the film in the stretched position at a moment when the evaporating wetting agent evaporates to adhere the second region of the film to the second frame. Finally, the method may comprise separating the second region of the film of HARM-structures from the first frame after the second region of the film of HARM-structures has adhered to the second frame.

The solution allows the film of HARM-structures, or a part thereof, to be transferred from one frame to another, i.e. from the first frame to the second frame. In particular, this can be done so that the film is stretched on the second frame after which the film sticks to the second frame. This allows introducing strain into the film, particularly in a manner where strain is introduced in the film plane of the free-standing film.

The evaporating wetting agent has a two-fold function: first lubrication and then bonding. The evaporating wetting agent lubricates the interface between the second frame and the film allowing the film to be stretched against the second frame. The evaporating wetting agent can thus reduce sliding friction between the film and the second frame and prevent the film from breaking upon stretching. This applies even when the strain on the film is increased. Secondly, the evaporating wetting agent can also provide a controlled way of engaging the film with the second frame. When the evaporating wetting agent evaporates, it allows the film to bond to the second frame in the stretched position. Bonding can thus take place as a continuous process at the interface with the spacing between the film and the second frame continuously decreased by evaporation of the evaporating wetting agent. This allows the film to bond to the second frame without relaxing strain of the film.

In an embodiment, the evaporating wetting agent is an organic wetting agent. This allows an improved wetting of the HARM-structures and/or the second frame, for example in comparison to water, in particular as the second frame can be a hydrophobic frame. It also allows faster evaporation, for example in comparison to water. Both the improved wetting and the faster evaporation allow improved bonding. When the HARM-structures comprise or consist of carbon nanostructures the organic wetting agent can be used to mitigate chemical modification of the film.

In an embodiment, the evaporating wetting agent has a surface tension lower than the surface energy of the second frame. This allows improving the bonding of the film to the second frame.

In an embodiment, the evaporating wetting agent is a low-polarity solvent.

In an embodiment, the evaporating wetting agent has an oxygen-containing functional group.

In an embodiment, the evaporating wetting agent comprises or consists of isopropyl alcohol.

In an embodiment, the evaporating wetting agent has a boiling point from 30 to 150 degrees Celsius. All values dependent on ambient temperature and/or pressures disclosed herein can be considered disclosed under NTP (normal temperature and pressure) conditions.

In an embodiment, the separating the second region of the film of HARM-structures from the first frame is at least partially performed chemically and/or mechanically.

In an embodiment, the evaporating wetting agent is deposited on the interface through the film of HARM-structures.

In an embodiment, the method comprises levelling of the second frame before the film of HARM-structures is in the stretched position. This allows sharing stretching force across the contact surface when they come into contact. In a further embodiment, the levelling is performed based on optical sensing of two or more edge positions of the second frame.

In an embodiment, strain of the film of HARM-structures is monitored by one or more strain sensors while the film of HARM-structures is in the stretched position. In a further embodiment, the one or more strain sensors comprises a chromatic confocal sensor.

In an embodiment, the HARM-structures comprise or consist of carbon nanotubes.

In an embodiment, separating the second region of the film of HARM-structures from the first frame comprises separating the second region of the film of HARM-structures from the first region of the film of HARM-structures after the second region of the film of HARM-structures has adhered to the second frame. In a further embodiment, the second region of the film of HARM-structures is separated from the first region of the film of HARM-structures along a border of the second frame.

According to a second aspect, an apparatus for preparing a free-standing film of HARM-structures is disclosed. The apparatus may comprise a clamp for clamping together a first frame for supporting a film of HARM-structures and a holding frame for pressing against the film of HARM-structures on the first frame to prevent peeling of the HARM-structures upon strain. The film of HARM-structures has a first region adhering to the first frame and a second region supported across an opening of the first frame. The apparatus comprises a dispenser for depositing an evaporating wetting agent on an interface to be formed between the film of HARM-structures and a second frame for supporting the second region of the film of HARM-structures. The apparatus may comprise an actuator for arranging the second frame from the opening of the first frame with relative movement between the first frame and the second frame. The apparatus may comprise a separator for separating the second region of the film of HARM-structures from the first frame.

It is to be understood that the aspects and embodiments described above may be used in any combination with each other. Several of the aspects and embodiments may be combined together to form a further embodiment of the invention.

### BRIEF DESCRIPTION OF THE DRAWINGS

The accompanying drawings, which are included to provide a further understanding and constitute a part of this specification, illustrate examples and together with the description help to explain the principles of the disclosure. In the drawings:
Figs. 1a and 1b illustrate preparing a free-standing film according to an example from two different views,
Fig. 2 illustrates a method according to an example, and
Fig. 3 illustrates an apparatus according to an example.

Like references are used to designate equivalent or at least functionally equivalent parts in the accompanying drawings.

### DETAILED DESCRIPTION

The detailed description provided below in connection with the appended drawings is intended as a description of examples and is not intended to represent the only forms in which the example may be constructed or utilized. However, the same or equivalent functions and structures may be accomplished by different examples.

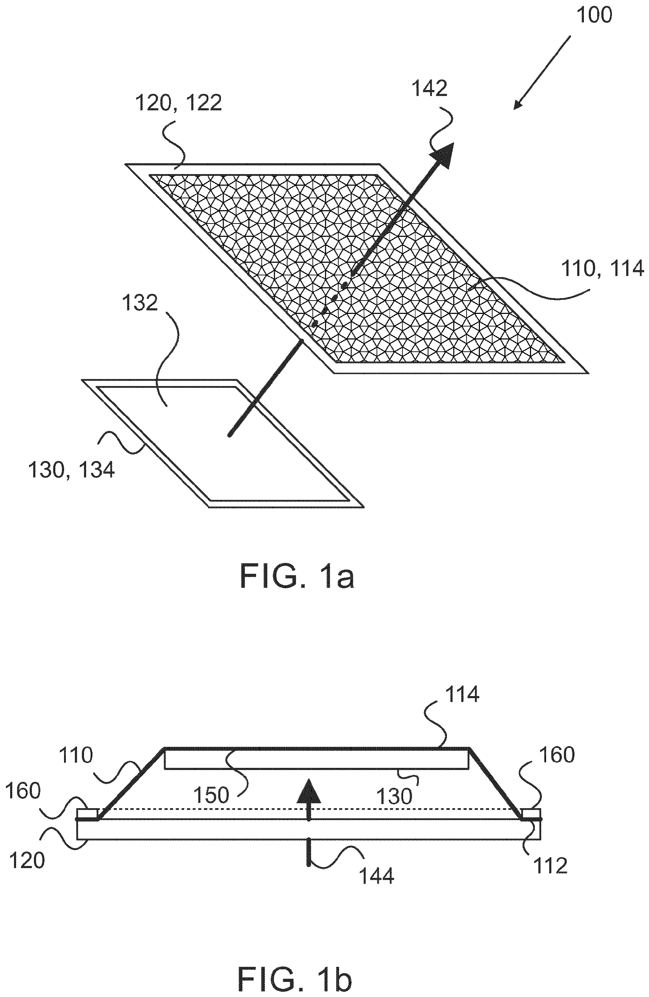

Figs. 1a and 1b show an example 100 of preparing a free-standing film 110 of HARM-structures (herein also "the free-standing film" or "the film", illustrated as a polygonal pattern). The free-standing film may be provided for example as disclosed in WO 2010/086504 A1. The free-standing film may be provided so that a middle part of the film, or a network of HARM structures thereof, is unsupported directly from below (i.e. free-standing). The free-standing film may be supported from two or more sides, for example by a supporting boundary encircling the middle part.

The free-standing film may be one that can exist on its own without the need for a substrate. It can be self-supporting, meaning that the film has sufficient mechanical integrity and strength to maintain its structure independently. A free-standing film may typically be directly formed as an independent entity but also a substrate-grown film may be produced so as to be free-standing after the substrate is removed. A defining characteristic of any free-standing film can be its ability to maintain its structure without a substrate. Regardless of whether the free-standing film is formed on a substrate or not, it can be considered free-standing if, after any processing steps, it can exist and function independently, in particular as described above. The free-standing film does not need to be directly supported throughout its whole area since it can maintain its structure without a direct support. It provides, by itself, an intrinsic structural support for maintaining its structure, e.g. its shape. This can be observed under gravity, in absence of supporting forces to the free-standing film. The free-standing film(s) as described herein can thus also be understood as self-supporting film(s).

The HARM structures may have length tens to thousands of times or larger than their maximum diameter. In this sense, they may be considered substantially one-dimensional structures. The HARM-structures may comprise or consist of carbon nanostructures, for example carbon nanotubes (CNTs), such as single-walled CNTs and/or multi-walled CNTs, carbon nanobuds (molecule having a fullerene molecule covalently bonded to the side of a carbon nano tube), carbon nanoribbons, or any combination thereof. Alternatively or additionally, the HARM-structures may comprise other types of HARM-structures such as cellulose fibers, nanorods or nanowires, e.g. silver nanowires. The HARM-structures may comprise or consist of uncoated structures and/or coated structures, such as coated CNTs. The film may comprise or consist of a substantially planar network of the HARM-structures. The HARM-structures may be oriented substantially randomly in the network. The HARM-structures may be electrically conductive HARM-structures.

The film of HARM-structures can be provided and/or received on a frame, which here is denoted as a first frame 120. Typically, the film of HARM-structures may be provided/received on an upper surface of the first frame 120 but it should be understood that the process may also be performed upside-down so that the film of HARM-structures is provided/received on a lower surface of the first frame 120. Similarly, the process may also be performed with the first frame positioned vertically or at any angle with respect to horizontal so that the film of HARM-structures is provided/received on a surface of the first frame 120 which is now a full or partial side surface of the first frame 120. The process is here generally described for the film of HARM-structures provided/received on an upper surface of the first frame 120 and any modifications to this positioning can be made accordingly.

The first frame 120 may be provided on a chuck (not illustrated), which also allows aligning the first frame 120. The first frame 120 has an opening (illustrated as being covered by the film 110) across which the film may be supported as a free-standing film. The opening may be at the center of the first frame 120. The frame may comprise a boundary 122 encircling the opening. The opening may be symmetric with respect to the rest of the first frame 120 and/or to the boundary. The first frame 120 allows the film to be provided thereupon so that the film has a first region 112 which adheres to the first frame 120, e.g. to the boundary (for clarity, the first region is not illustrated in Fig. 1 but it may be considered to extend on the boundary of the first frame 120 as illustrated). The first region may correspond to a boundary of the film. It may be fully supported on the boundary of the first frame 120 or it may extend partially across the opening. The film may then have a second region 114 supported across an opening of the first frame 120. The second region may be considered as a free-standing region (initially) supported by the first region. The second region is thus within the first region, e.g. as delimited by the first region. The first region and the second region may be equiplanar (i.e. within the same plane) when the film is at rest on the first frame 120. The first region may be homogeneous with respect to the second region, changing seamlessly to the second region. The first frame 120 may be a hydrophobic frame.

A second frame 130 may also be provided. The second frame 130 is sized and shaped to fit through the opening of the first frame 120. This allows the second frame 130 to be moved through 142 the first frame 120 from the opening into contact with the film. Alternatively or additionally, the first frame 120 may be moved for the same effect. In particular, the second frame 130 may be arranged for fitting through the first frame 120, in particular when the first frame 120 and the second frame 130 are to be in parallel orientation. The second frame 130 may be arranged 144 from the opening to a position where the film of HARM-structures is stretched into a stretched position, in particular with a stretching force perpendicular to a film plane of the film of HARM-structures. The second frame 130 may also have an opening 132 across which the film, in particular a portion thereof, may also be supported as a free-standing film. This opening may be at the center of the second frame 130. The second frame 130 may comprise a boundary 134 of the second frame 130 encircling the opening of the second frame 130. The opening of the second frame 130 may be symmetric with respect to the rest of the second frame 130 and/or to the boundary thereof. The second frame 130 may be a hydrophobic frame.

Fig. 1a illustrates, from a perspective view, how the second frame 130 may be moved with respect to the film 110 and the first frame 120. With all the references herein to movement of the second frame 130 or the second frame 130 being moved, it should be understood that the second frame 130 may be moved with relative movement between the first frame 120 and the second frame 130, i.e. either only the first frame 120 is moved, only the second frame 130 is moved or both the first frame 120 and the second frame 130 are moved.

Fig. 1b illustrates, from a side view, how the second frame 130 may be arranged, i.e. moved as de-scribed above, from the opening of the first frame 120 to a position (herein also "the final position") where the second frame 130 is in contact with the film of HARM-structures for stretching the film into the stretched position. The second region of the film of HARM-structures is supported by the second frame 130 as the free-standing film. An initial position for the relative movement may be where the second frame 130is within the opening of the first frame 120, i.e. at the level of the first frame 120, or below it. The relative movement for the second frame 130 from the opening, or all the way from the initial position, to the final position may take place directly, i.e. as a single linear unidirectional movement, or it may comprise multiple subsequent movements, which may include intermittent movement and/or bidirectional movement. The relative movement allows a stretching force to be effected on the film of HARM-structures perpendicularly to the film of HARM-structures by the second frame 130. The first frame 120 and/or the second frame 130 may be supported on the chuck.

The film of HARM-structures on the first frame 120 may already be pre-stretched (even if we may refer this to as an unstretched position or state). The stretching force in such a case is in a film plane of the film of HARM-structures. In the stretched position as described herein, the stretching force is, in contrast, away for the film plane of the film of HARM-structures. It can be understood as a perpendicular force component with respect to the film plane of the film of HARM-structures. It may thus also correspond to a force component perpendicular to the first frame 120.

The first frame 120 and the second frame 130 may be provided in various shapes and sizes. The first frame 120 and/or the second frame 130 may be a rectangular frame or an oval frame. The first frame 120 and/or the second frame 130 may be a quartz frame. In addition or instead of quartz, the first frame 120 and/or the second frame 130 may comprise or consist any of PEEK (polyether ether ketone), PMMA (poly(methyl methacrylate)), PVC (polyvinyl chloride), other polymers, aluminium, stainless steel and silicon but possibly also one or more other materials. It has been found that using quartz allows improved thermal stability, whereas using polymers allows improved adhesion for the film to a frame, such as the second frame 130. The first frame 120 and the second frame 130 may be provided as supporting frames for supporting the free-standing film.

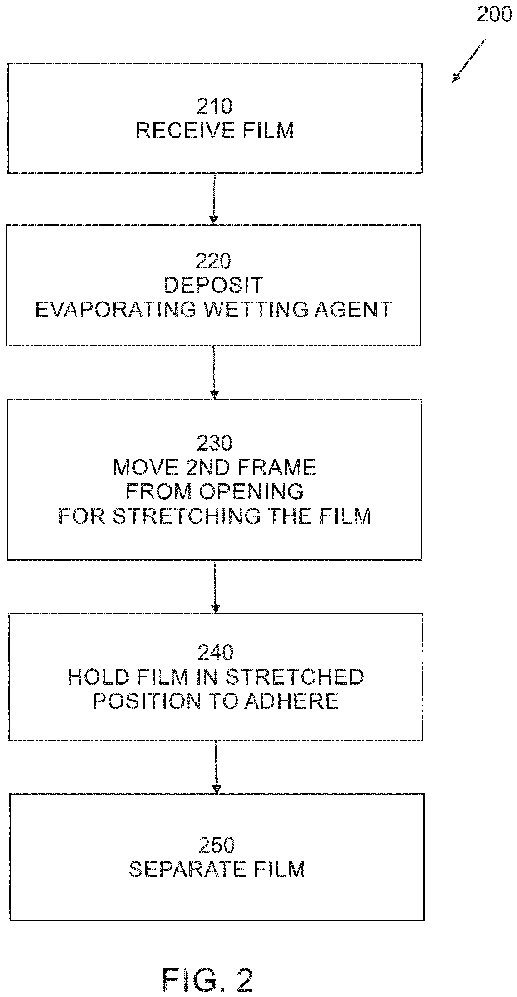

Fig. 2 shows an example of a method 200, which may be used for preparing the film. The film 110, as described above, is received 210 on the first frame 120. On the second frame 130, an evaporating wetting agent (herein also "the wetting agent") is deposited 220 (herein also "the depositing"). It is deposited on an interface to be formed between the second frame 130 and the film of HARM-structures, for example on the boundary of the second frame 130, so that the second frame 130 can be brought into contact with the film of HARM-structures, via the interface, for supporting the second region of the film as a free-standing film with the second frame 130. The wetting agent may be deposited on the second frame 130, in particular on a side to be facing the film of HARM-structures, and/or on the film of HARM-structures, in particular on a side to be facing the second frame, for example through the film of HARM-structures. The wetting agent may be deposited, partially or fully, directly on the second frame 130. Alternatively or additionally, it may be deposited, partially or fully, on the interface. For this purpose, the film may be indented, manually and/or automatically, for example in case the too thick or not porous enough so as not to naturally let the wetting agent through. The wetting agent may be deposited through the film of HARM-structures already before the film of HARM-structures is in contact with the second frame. The HARM-structures may be porous allowing the wetting agent to penetrate the film to contact the second frame 130.

The wetting agent may be deposited downwards, e.g. on the second frame 130 and/or through the film of HARM-structures. Alternatively or additionally, the wetting agent may be deposited upwards, e.g. on the film of HARM-structures. Conversely, if the process is performed with the first frame 120 and the second frame 130 upside-down, i.e. the film of HARM-structures provided on a lower surface of the first frame, the wetting agent may be deposited downwards on the film of HARM-structures.

Regardless of how the wetting agent is deposited on the interface, the wetting agent forms a contact surface 150 between the second frame 130 and the second region of the film of HARM-structures, when the second frame 130 is moved 230 from the opening of the first frame 120 into contact with the film (herein also "the moving"), in particular for stretching the film into the stretched position. For this purpose, the wetting agent may be provided encircling the opening of the second frame 130. The interface may thus be formed at the contact surface. The moving may alternatively or additionally be performed by moving the first frame 120 so that the second frame 130 is arranged from the opening of the first frame 120 to a position where the second frame is in contact with the film. Thus, the moving can be performed with relative movement of the first frame 120 and the second frame 130 by actual movement of the first frame 120 and/or the second frame 130. It may be enough, in the stretched position, for the second frame 120 only by a small amount, such as 0.5-2 millimeters, but it may naturally be elevated also more, e.g. up to 10 millimeters or more. For example, an elevation of 1.3 millimeters may yield a total stretch of 0.7% on the film of HARM-structures. The stretch of the film of HARM-structures in the stretched position (as indicated as a relative increase in length of the portion of the film of HARM-structures free-standing within the first frame 120 before the second frame 130 is brought into contact with the film of HARM-structures when said portion is stretched into the stretched position) can be, for example, 0.2-2% but also more or less. The contact may be formed via the interface, initially through the contact surface and thereby via the wetting agent, which can then evaporate to allow the film of HARM-structures to adhere to the second frame 130 in direct contact. The wetting agent allows the contact surface to be wet, and thereby slippery, when the second region of the film of HARM-structures is transferred from the first frame 120 to the second frame 130, while maintaining tension on the film of HARM-structures and the second region thereof.

The wetting agent can first provide a bearing for lubrication, then evaporate to facilitate bonding. It thus allows reducing static friction between the film and the second frame 130 at the contact surface so that the film can be more easily stretched over the second frame 130. However, as it evaporates it allows the adhesion between the film and the second frame 130 to be increased while the film is in the stretched position. The wetting agent may be provided as a uniform layer on the second frame 130. It may be deposited as single droplets and/or by continuous dispensing. The wetting agent may be provided as a fluid, e.g. as a liquid, which may be maintained on the second frame 130 by surface tension.

Any evaporating wetting agent known to a person skilled in the art may be used. In particular, the wetting agent may comprise or consist of any of the following, alone or in any combination: alcohol, ketone and acetate ester. The wetting agent may be organic or inorganic wetting agent, or a combination thereof. The wetting agent may comprise or consist of a low-polarity solvent. These can include hydrocarbons, nonpolar solvents or anything with polarity lower than water. The wetting agent may have an oxygen-containing functional group. The wetting agent may, in particular, comprise or consist of isopropyl alcohol (IPA), which can be provided as a low-polarity solvent. The wetting agent may be a solvent but is not limited thereto. It may also comprise or consist of fluid/liquid polymers.

In general, the wetting agent may comprise water. In particular, the wetting agent may comprise or consist of two or more components, for example an evaporating component, such as water, and an adhering component, such as an adhesive. As an example, the wetting agent may comprise or consist of a water-activated polyurethane adhesive. Polyurethane adhesives may bond well to both CNT films and metals, and they can cure after water is removed, e.g. by evaporation. Humidity sensor, such as a hygrometer, placed near or around the adhesive area can be used to monitor if water is still present. One simple way is to measure the weight of the whole system periodically: Once the weight stabilizes and no further loss of weight is detected the water can be considered fully evaporated.

The wetting agent may have a surface tension lower than a surface tension of water and/or the surface energy of the second frame 130. It may have a boiling point of at least 30 degrees Celsius and/or at most 150 degrees Celsius (NTP) but also larger or smaller. The surface energy may be measured with a contact angle measurement. This method involves measuring the contact angle formed by a droplet of liquid on the material's surface. The contact angle can be influenced by the balance between adhesive and cohesive forces at the solid-liquid interface. Procedurally, a droplet of a known liquid is placed on the material's surface, and the contact angle is measured using an optical instrument. The shape of the droplet provides information about the surface energy. Alternatively, the surface energy and/or the surface tension may be measured by a dyne test and expressed in dynes per centimeter (dyn/cm). This involves applying a liquid of known surface tension to the material's surface and observing the behavior of the liquid droplet. The test is based on the principle that the contact angle formed by the droplet on the material's surface provides information about the surface energy.

The first frame 120 and the second frame 130 may be clamped together, for example before the depositing, in particular so that the second frame 130 is within the first frame 120, in particular in the opening thereof. The first frame 120 and the second frame 130 may thus be aligned with respect to each other. Alternatively or additionally, the first frame 120 may be clamped together with a holding frame 160 for pressing against the film of HARM-structures on the first frame 120 to prevent peeling of the HARM-structures upon strain (herein also "the clamping"). In all the above-mentioned cases, a clamp such as a vacuum clamp may be used for clamping. The vacuum clamp allows holding the corresponding frames 120, 130, 160 together without breaking or causing damage to the surface of said frames 120, 130, 160. The vacuum clamp also allows pressure to be evenly divided across the surface of the frame(s) 120, 130, 160 to be clamped. It can also allow leaving the surface fully accessible, allowing for easier machining and/or assembly. The vacuum clamp can allow faster setup times by removing the need to manually adjust and/or tighten multiple clamps. With the vacuum clamp, no physical contact is necessitated with the corresponding frame(s) 120, 130, 160, reducing the risk of contamination, e.g. from oils, adhesives or other residues that may be present on traditional clamp surfaces. The vacuum clamp allows consistent pressure distribution across the surface, e.g. the entire surface, of the frame(s) 120, 130, 160 to be clamped, thereby ensuring uniformity in clamping force and minimizing the risk of distortion or warping. The vacuum clamp may be easily integrated with automated systems, allowing for seamless integration into CNC (computer numerical control) machining and/or robotic assembly.

The film of HARM-structures may be 240 in the stretched position while the evaporating wetting agent evaporates to adhere the second region of the film to the second frame 130 (herein also "the adhering"). In particular, this involves having the film of HARM-structures in the stretched position at a moment when the wetting agent evaporates so that the second region of the film of HARM-structures adheres to the second frame 130. The stretched position is the specific position where the adherence takes place so the film of HARM-structures may be held at this specific position only for a short time or it may be maintained there for an extended time. For example, the second frame may be moved from the opening of the first frame directly to the final position where the film of HARM-structures is in the stretched position, so that the wetting agent is allowed to fully evaporate in the stretched position, or it may be moved to the final position only for a short time when the wetting agent finally evaporates so that the second region of the film of HARM-structures adheres to the second frame. The film may be moved to the stretched position directly from the opening and then maintained at the stretched position until the second region of the film adheres to the second frame 130. However, it should be understood that it is enough to maintain the film in the stretched position just for the second region of the film to adhere to the second frame 130. Before and/or after the adhering, the second frame 130 may be additionally (relatively) moved with respect to the first frame 120, including into one or more additional stretched positions, where the stretching of the film may be different, e.g. greater or smaller, from the stretching of the film in the stretched position where the second region of the film adheres to the second frame 130. The film may be maintained in the stretched position for a threshold time for the adhering. The threshold time may be less than 30 seconds, 30-60 seconds or more than 60 seconds, for example depending on the circumstances.

The second frame 130 may be levelled before the film is in the stretched position for sharing stretching force across the contact surface (herein also "the levelling"). This can be done before the second region has adhered to the second frame 130. For the levelling, the second frame 130 may be tilted until the contact surface is horizontal, i.e. until both dimensions (x-dimension and y-dimension) defining the contact surface are horizontal. The levelling may be performed based on optical sensing, using one or more optical sensors. For example, two or more edge positions of the second frame 130 may be identified by optical sensing for this purpose. In general, strain of the film may be monitored, in particular in the stretched position. The monitoring may be performed by a non-contact method, in particular for measuring strain within the boundaries of the second frame 130 area in-situ, e.g. within the second region of the film. The monitoring may be performed using one or more strain sensors, in particular chromatic confocal sensors. The strain sensor(s) may be configured for xy-mapping of the film, or the surface thereof. A sagging model may be used for estimating the strain level. Additional in-plane strain may also be created, for example by creating a pressure gradient over the film and/or an electric current bias through the film.

After the second region of the film of HARM-structures has adhered to the second frame 130, the second region of the film of HARM-structures may be separated 250 from the first frame 120 (herein also "the separating"). As a result, the second region of the film is provided as a free-standing film on the second frame 130. The separating may comprise or consist of separating the second region of the film of HARM-structures from the first frame 120 by separating the first region of the film of HARM-structures from the first frame 120 and/or by separating the second region of the film of HARM-structures from the first region of the film of HARM-structures. This may be done, partially or fully, chemically, mechanically, optically or by other non-mechanical means. For example in in the latter case, the film of HARM-structures may be chemically, mechanically or optically cut between the first region and the second region. Mechanical separation may involve mechanical cutting, e.g. by scissors, by a razor blade, by a scalpel, by die cutting or by a microtome. Mechanical separation may involve solvents or other chemical processes. Optical separation may involve optical cutting, e.g. by laser cutting. Other non-mechanical means may involve ultrasonic cutting, electrochemical cutting, plasma cutting, focused ion beams (FIB) or waterjet cutting. The separating may be performed along a border, such as an inner border, of the first frame 120 and/or along a border, such as an outer border, of the second frame 130. The separating may also be performed in any region of the film of HARM-structures between the first frame 120 and the second frame 130, at a distance from the border of the first frame 120 and the border of the second frame 130.

The strain for the second region, in particular in the plane of the second region, may now be larger than the strain of the film, in particular in the plane of the film, when it was supported by the first frame 120 (e.g. in an unstretched position or state). The focal length of a laser performing the separating may be adjusted during the cut, for example by automatic adjustment. A chromatic confocal sensor may be utilized for providing a mapping of the film, or the surface thereof, for adjusting the focal length. The same chromatic confocal sensor may be used for both monitoring and automating the laser cutting process and as the strain sensor, as described above.

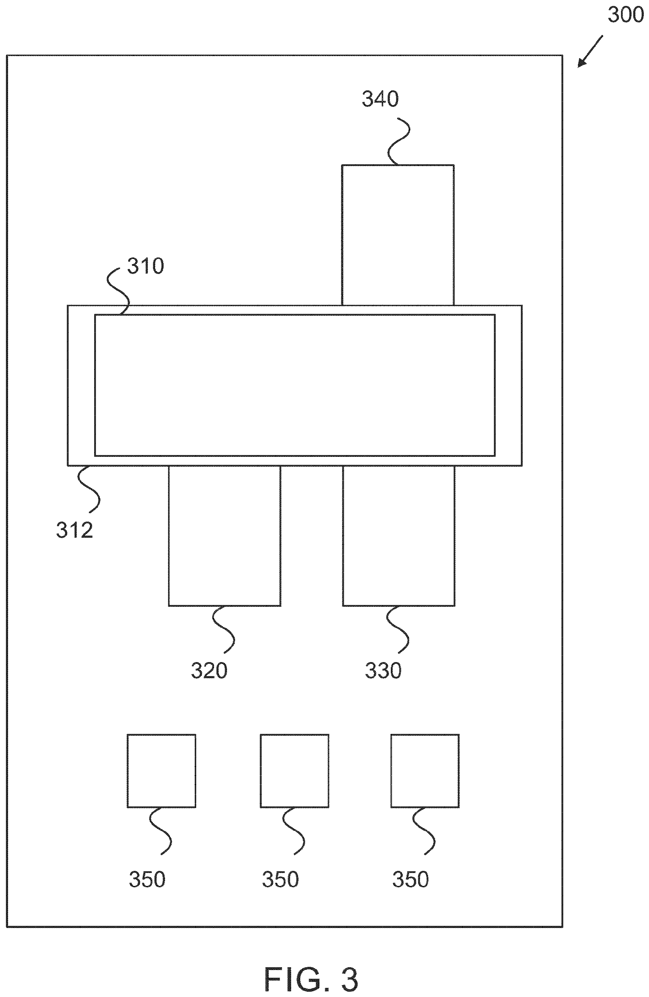

Fig. 3 shows an example of an apparatus for preparing the free-standing film of HARM-structures, for example as described above. The apparatus may comprise any or all of the elements described in the following.

The apparatus may comprise one or more clamps 310 for clamping together the first frame 120 and the holding frame 160 and/or for clamping together the first frame 120 and the second frame 130, in particular so that the second frame 130 may be thus clamped within the first frame 120, or within the opening thereof. The apparatus may be configured for using the clamp(s) for performing any or all features pertaining to the clamping as described above. The first frame 120 and/or the second frame 130 may be positioned on the chuck 312, which may also be part of the apparatus. The apparatus may be configured for clamping the corresponding frames, e.g. the first frame 120 and the second frame 130 and/or the first frame 120 and the holding frame 160 together automatically and/or manually in response to a user input. This allows aligning said frames 120, 130, 160, which the apparatus may also be configured to do, for example to follow a set of alignment parameters. The clamp(s) may be configured for allowing controlled movement of the frames 120, 130, 160 to be clamped with respect to each other, for example in only one dimension such as a dimension through the opening of the first frame 120 (z-dimension), which may also be considered a dimension perpendicular to the film when the film is supported on the first frame 120. The clamp(s) may comprise one or more vacuum clamps. The first frame 120 and/or the second frame 130 may be part of the apparatus or provided separately. This also applies to the holding frame 160. The holding frame may be configured for pressing against the film of HARM-structures on the first frame 120 to prevent peeling of the HARM-structures upon strain. It may have the same shape, e.g. a rectangular shape or an oval shape, as the first frame 120.

The apparatus may comprise one or more dispensers 320 for depositing the evaporating wetting agent on the interface to be formed between the film of HARM-structures and the second frame 130, e.g. on the second frame 130 and/or on the film of HARM-structures. The apparatus may be configured for using the dispenser(s) for performing any or all features pertaining to the depositing as described above. The apparatus may be configured for depositing the evaporating wetting agent automatically and/or manually in response to a user input. The dispenser(s) may be configured for depositing the wetting agent as single droplets and/or by continuous dispensing. The dispenser(s) may be configured for automated and/or manual motion around the film for depositing the wetting agent.

The apparatus may comprise one or more actuators 330 for arranging the second frame 130 from the opening of the first frame 120. The one or more actuators may comprise or consist of linear actuators and/or nonlinear actuators. As noted above, this may be performed with the relative movement between the first frame 120 and the second frame 130 so the one or more actuators may be configured for moving the first frame 120 and/or the second frame 130. The one or more actuators may comprise one or more first actuators for moving the first frame 120 and/or one or more second actuators 130 for moving the second frame. For example, the one or more actuators may comprise a first linear actuator for moving the second frame 130 through the opening of the first frame and/or a second linear actuator for moving the first frame 120 so that the second frame follows through the opening of the first frame 120. The apparatus may be configured for using the actuator(s) for performing any or all features pertaining to the arranging as described above. The apparatus may be configured for performing the relative movement automatically and/or manually in response to a user input. The actuator(s) may be configured for linear movement in the dimension perpendicular to the film when the film is supported on the first frame 120 (z-dimension). The actuator(s) may comprise one or more pneumatic lifts. The apparatus may be configured for using the actuator(s) for performing any or all features pertaining to the levelling as described above. Alternatively or additionally, the apparatus may comprise one or more levelling actuators, separate from the actuator(s) mentioned above, for this purpose.

The apparatus may comprise one or more separators 340, such as cutters, for separating the second region of the film of HARM-structures from the first frame 120 and/or for separating the second region of the film of HARM-structures from the first region of the film of HARM-structures. The apparatus may be configured for using the separator(s) for performing any or all features pertaining to the separating as described above. The apparatus may be configured for separating the second region from the first region automatically and/or manually in response to a user input. The separator(s) may be configured for automated and/or manual motion around the film for depositing the wetting agent. The separator(s) may be configured for mechanical cutting, optical cutting, chemical cutting, other non-mechanical cutting or any combination thereof. This includes all the means for separation described above. For example, the separator(s) may comprise or consist of one or more mechanical cutters such as scissors, razor blades, scalpels, die cutters or microtomes. The separator(s) may also comprise or consist of one or more chemical dispensers and/or laser cutters, or by any means for separation as described above.

The apparatus may comprise one or more monitoring devices 350 for monitoring the film and/or any elements, such as the first frame 120 and/or the second frame 130. The monitoring device(s) may comprise one or more optical sensing devices and/or strain sensors. The optical sensing device(s) may be configured for optical sensing of the level of the film, for example by laser distancing. The strain sensor(s) may be configured for measuring strain of the film in two or more dimensions, for example in the two dimensions of the film plane (x-dimension and y-dimension). The strain sensor(s) may comprise a chromatic confocal sensor, which may be configured to be used for the abovementioned purpose.

One example of process flow for preparing a free-standing film of HARM-structures is as follows. The second frame 130 is placed on the chuck without clamping. A continuous film of the wetting agent, e.g. IPA, is deposited onto the surface of the second frame 130 by dispensing a number of droplets, for example with a volume of 10 microliters each, spaced by a distance, such as 1 cm, along the entire length of the second frame 130. For example 48 drops may be used for the second frame 130. The droplets are spread and bubbles can be removed manually, e.g. by the tip of a pipette. A continuous film of the wetting agent can be formed, for example in less than 30 seconds.

As above, depositing the wetting agent serves the purpose of reducing static friction between the film and the surface of the second frame 130 so that the film can be stretched over the second frame 130. The film may be fixed solely by adhesion on the surface of the first frame 120. The wetting agent, here IPA, has the function of a lubricant or a bearing.

The chuck with the second frame 130 containing the wetting agent may be lowered with an actuator, such as a pneumatic lift, and the first frame 120 may be placed on an outer chuck. The wetting agent, deposited as a layer, may be left to thin by evaporation for a time, such as 10-20s. After this, the actuator may be moved to arrange, by the relative movement, the second frame 130 into contact with the film of HARM-structures via the contact interface, so that the film of HARM-structures is in the stretched position. In the stretched position, the second frame 130 may be a distance, such as 1 millimeter, apart from the first frame 120. All measurements indicated herein for the second frame 130 and the first frame 120 may be considered to be taken at an upper surface of the corresponding frame, or at the surface facing the film of HARM-structures, which can be for example a lower surface of the corresponding frame if the process is carried out upside-down as described above.

Strain induced in the film within the boundaries of the second frame 130 may be approximated as uniform two-dimensional elastic strain as long as sliding friction is small enough (due to lubrication by the wetting agent). The geometry of the second frame 130 can minimize stress concentration points, for example on corners.

After the wetting agent has evaporated from between the second frame 130 and the film of HARM-structures, the second region may be cut out from the first frame 120 so that it remains attached to the second frame 130. For this purpose, a cut may be initiated by dispensing a drop of a chemical agent, such as IPA, onto the film, e.g. on the first region, by a cutter, such as a micropipette tip. The cutter may be moved along the whole length of the second frame 130, for example in an intermittently linear motion. The chemical agent may be constantly or intermittently dispensed while moving the cutter. When the wetting agent has evaporated from between the film of the HARM-structures and the second frame 130, cutting out the film can have a minimal effect on the strain within the second region.

Another example of process flow for preparing a free-standing film of HARM-structures is as follows. The example can also be considered as a general description of the function of the apparatus. The apparatus performs a transfer operation comprising:
- clamping the first frame 120 and the second frame 130 with a clamp, such as a vacuum clamp,
- depositing the wetting agent, such as IPA, onto the second frame 130,
- moving the second frame 130 through the first frame 120, with the deposited wetting agent facing the first region of the frame which holds a freestanding film of HARM-structures, such as CNTs, and
- cutting the film out so that the second frame 130 is left covered with a free-standing film (the second region of the film).

An example of technical specifications for each step is as follows.
- For the clamping, the clamping force on the first frame 120 and the second frame 130 may be above a threshold force so that neither of the frames will experience a visual displacement during any step of the full process.
- For the depositing, the apparatus may deposit individual single droplets of the wetting agent, such as IPA, with discrete volumes, e.g. of 5 - 50 microliters, in discrete steps, and/or perform a continuous dispensing, for example of at least 1 microliter per second, while moving the dispenser along the surface of the second. In any mode of operation, a bubble-free layer of wetting agent, such as an IPA layer, may be formed on the surface of the second frame 130. The method of preparing may be parametrized so that the wetting agent is not locally depleted by evaporation for at least 30 seconds, for example by choice of the wetting agent or the amount thereof.
- For the moving, the end distance (at the stretched position) of the surface of the second frame 130 to the surface of the first frame 120 may be adjustable with an accuracy of at least 0.1 mm. It may be adjustable, for example in a range between -2 mm and +10 mm. The plane of the second frame 130 may be aligned with the plane of the first frame 120, for example so that their relative rotation is at most 0.1 degrees in any direction.
- For the depositing, the dispenser may be arranged to have the wetting agent penetrate the film, for example by a combination of dispensing the wetting agent and performing one or more indentations on the film. The dispenser may also be positioned so that it can dispense from beneath the film of HARM-structures.

The different functions discussed herein may be performed in a different order and/or concurrently with each other.

Any range or device value given herein may be extended or altered without losing the effect sought, unless indicated otherwise. Any example may be combined with another example unless explicitly disallowed.

Although the subject matter has been de-scribed in language specific to structural features and/or acts, it is to be understood that the subject matter defined in the appended claims is not necessarily limited to the specific features or acts de-scribed above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The term 'comprising' is used herein to mean including the method, blocks or elements identified, but that such blocks or elements do not comprise an exclusive list and a method or apparatus may contain additional blocks or elements.
Numerical descriptors such as 'first', 'second', and the like are used in this text simply as a way of differentiating between parts that otherwise have similar names. The numerical descriptors are not to be construed as indicating any particular order, such as an order of preference, manufacture, or occurrence in any particular structure.

Although the invention has been described in conjunction with a certain type of apparatus and/or method, it should be understood that the invention is not limited to any certain type of apparatus and/or method. While the present inventions have been described in connection with a number of examples, embodiments and implementations, the present inventions are not so limited, but rather cover various modifications, and equivalent arrangements, which fall within the purview of the claims. Although various examples have been described above with a certain degree of particularity, or with reference to one or more individual embodiments, those skilled in the art could make numerous alterations to the disclosed examples without departing from the scope of this specification.

## Claims

1. A method of preparing a free-standing film of high aspect ratio molecular structures (HARM-structures), the method comprising:
- receiving a film of HARM-structures on a first frame, the film of HARM-structures having a first region adhering to the first frame and a second region supported across an opening of the first frame;
- depositing, on an interface to be formed between a second frame for supporting the second region as a free-standing film and the film of HARM-structures, an evaporating wetting agent;
- with relative movement between the first frame and the second frame, arranging the second frame from the opening of the first frame to a position where the second frame is in contact with the film of HARM-structures for stretching the film of HARM-structures into a stretched position where the second region of the film of HARM-structures is supported by the second frame as the free-standing film, the evaporating wetting agent forming a contact surface between the second frame and the second region of the film of HARM-structures;
- having the film of HARM-structures in the stretched position at a moment when the evaporating wetting agent evaporates so that the second region of the film of HARM-structures adheres to the second frame; and
- separating the second region of the film of HARM-structures from the first frame after the second region of the film of HARM-structures has adhered to the second frame.

2. The method of claim 1, wherein the evaporating wetting agent is an organic wetting agent.

3. The method of claim 1 or 2, wherein the evaporating wetting agent has a surface tension lower than the surface energy of the second frame.

4. The method of any of the preceding claims, wherein the evaporating wetting agent is a low-polarity solvent.

5. The method of any of the preceding claims, wherein the evaporating wetting agent has an oxygen-containing functional group.

6. The method of any of the preceding claims, wherein the evaporating wetting agent comprises or consists of isopropyl alcohol.

7. The method of any of the preceding claims, wherein the evaporating wetting agent has a boiling point from 30 to 150 degrees Celsius (NTP).

8. The method of any of the preceding claims, wherein the evaporating wetting agent is deposited on the interface through the film of HARM-structures.

9. The method of any of the preceding claims, comprising levelling of the second frame before the film of HARM-structures is in the stretched position.

10. The method of claim 9, wherein the levelling is performed based on optical sensing of two or more edge positions of the second frame.

11. The method of any of the preceding claims, wherein strain of the film of HARM-structures is monitored by one or more strain sensors while the film of HARM-structures is in the stretched position.

12. The method of claim 11, wherein the one or more strain sensors comprises a chromatic confocal sensor.

13. The method of any of the preceding claims, wherein the HARM-structures comprise or consist of carbon nanotubes.

14. The method of any of the preceding claims, wherein separating the second region of the film of HARM-structures from the first frame comprises separating the second region of the film of HARM-structures from the first region of the film of HARM-structures after the second region of the film of HARM-structures has adhered to the second frame.

15. The method of claim 14, wherein the second region of the film of HARM-structures is separated from the first region of the film of HARM-structures along a border of the second frame.

16. The method of any of the preceding claims, wherein separating of the second region of the film of HARM-structures from the first frame is at least partially performed chemically and/or mechanically.

17. An apparatus for preparing a free-standing film of HARM-structures, the apparatus comprising:
- a clamp for clamping together a first frame for supporting a film of HARM-structures, wherein the film of HARM-structures has a first region adhering to the first frame and a second region supported across an opening of the first frame, and a holding frame for pressing against the film of HARM-structures on the first frame to prevent peeling of the HARM-structures upon strain,
- a dispenser for depositing an evaporating wetting agent on an interface to be formed between the film of HARM-structures and a second frame for supporting the second region of the film of HARM-structures,
- an actuator for arranging the second frame from the opening of the first frame with relative movement between the first frame and the second frame; and
- a separator for separating the second region of the film of HARM-structures from the first frame.
